# FASCICULE DE BREVET EUROPEEN

(11) **EP 4 002 482 B1**
(45) Date de publication et mention de la délivrance du brevet: **07.05.2025**
(21) Numéro de dépôt: 21208504.7
(22) Date de dépôt: 16.11.2021
(51) Int. Cl.: H01L 29/66, H01L 29/78

(54) **PROCÉDÉ DE FABRICATION D'UNE ZONE DOPÉE D'UN DISPOSITIF MICROÉLECTRONIQUE**
VERFAHREN ZUR HERSTELLUNG EINES BEREICHS, DER MIT EINER MIKROELEKTRONISCHEN VORRICHTUNG DOTIERT IST
METHOD FOR MANUFACTURING A DOPED AREA OF A MICROELECTRONIC DEVICE

(30) Priorité: 18.11.2020 FR 2011824
(43) Date de publication de la demande: 25.05.2022
(73) Titulaire: Commissariat à l'Energie Atomique et aux Energies Alternatives, 75015 Paris (FR)
(72) Inventeur: REBOH, Shay, 38054 GRENOBLE Cedex 09 (FR)
(74) Mandataire: Hautier IP

(56) Documents cités:
- EP-A1- 2 765 599
- WO-A2-2004/008489
- US-A1- 2004 132 258
- US-B1- 6 232 641

## Description

### DOMAINE TECHNIQUE

La présente invention concerne le domaine de la microélectronique. Elle trouve pour application particulièrement avantageuse la réalisation de sources et drains dans des transistors requérant de faibles budgets thermiques, notamment dans le domaine de l'intégration 3D monolithique.

### ETAT DE LA TECHNIQUE

Historiquement, les développements de l'industrie des semi-conducteurs visent à suivre, à travers une feuille de route commune, la loi de Moore, qui prévoit le doublement de la densité des puces électroniques tous les dix-huit mois environ. Les nœuds technologiques jalonnant cette feuille de route sont généralement définis par la finesse de gravure des transistors des circuits intégrés.

Pour les nœuds technologiques dont la finesse de gravure est inférieure à 10 nm, les développements requis sont extrêmement complexes et coûteux. Une solution alternative aux nœuds technologiques les plus avancés, relâchant une partie des contraintes liées à la finesse de gravure, consiste à intégrer les transistors selon une architecture tridimensionnelle (3D). Ce concept d'intégration 3D est une solution prometteuse pour améliorer globalement les critères relatifs de puissance/performance/encombrement/coût des circuits intégrés, selon une démarche dite « More than Moore » (ou « au-delà de la loi de Moore », en français) tout en permettant une co-intégration de différents dispositifs sur différents niveaux.

Parmi les procédés d'intégration 3D à très grande échelle (ou 3D VLSI pour *Very Large Scale Integration* en anglais), le procédé d'intégration CoolCube^{™} propose de former des transistors les uns sur les autres de manière séquentielle. Une problématique de ce procédé concerne la gestion du budget thermique lors de la formation des couches supérieures de transistors. Afin de préserver les caractéristiques électriques optimales des transistors des couches inférieures de l'empilement, il faut limiter au maximum l'élévation de température lors des différentes étapes du procédé. En particulier, la formation de zones dopées de part et d'autre du canal du transistor, typiquement les zones de source et de drain du transistor, requiert classiquement une étape d'activation et/ou de diffusion des dopants, après implantation ionique d'espèces dopantes.

Une solution classique pour l'activation des dopants dans le cadre d'une technologie planaire consiste à effectuer un recuit thermique haute température, typiquement à une température T > 1000°C, après implantation des dopants.

Une solution existante pour l'activation des dopants dans le cadre d'une technologie d'intégration 3D consiste à amorphiser une partie de la couche semi-conductrice destinée à former les zones de source et de drain, avant ou pendant l'implantation des dopants. Après implantation des dopants, l'activation des dopants se fait lors de la recristallisation en phase solide de la couche semi-conductrice amorphe. Cette étape de recristallisation/activation peut se faire à plus basse température, typiquement à une température T < 600°C.

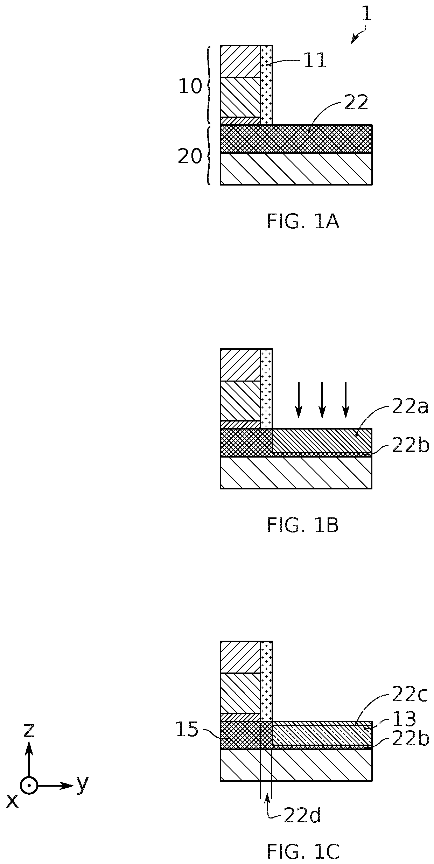

Les figures 1A-1C présentent les étapes d'un tel procédé de recristallisation appelé SPER (acronyme de « solid-phase epitaxial regrowth » selon la terminologie anglo-saxonne). La figure 1A illustre un dispositif 1 destiné à former un transistor et comprenant un motif de grille 10 flanqué d'un espaceur 11 sur un substrat 20 de type SOI (acronyme de « Silicon on Insulator » ou « silicium sur isolant » en français). La figure 1B illustre un bombardement d'ions en bordure de l'espaceur 11, adapté pour amorphiser partiellement la couche de silicium supérieure 22 (topSi) du substrat SOI, et pour implanter des dopants dans cette partie amorphe 22a. Une partie cristalline 22b de la couche topSi est conservée à l'issue de ce bombardement, de façon à former un germe pour la future recristallisation. La figure 1C illustre la recristallisation partielle du topSi à partir de ce germe 22b. Lors de la recristallisation, les dopants sont incorporés et activés. Cette recristallisation permet *in fine* d'obtenir une zone dopée 13.

Un inconvénient de cette solution basée sur le procédé de recristallisation SPER est qu'il existe une zone non dopée 22d entre le canal 15 et la zone dopée 13, sous l'espaceur 11. Cela augmente la résistance d'accès du transistor. Un autre inconvénient est la présence du germe 22b non dopé sous-jacent à la zone dopé 13. Cela augmente encore la résistance d'accès du transistor. En outre, pour de faibles épaisseurs de topSi, par exemple inférieures à 10 nm, un bon contrôle de la profondeur d'amorphisation devient essentiel. La mise en œuvre du procédé SPER est dès lors complexe. Par ailleurs, la recristallisation de la partie amorphe 22a du topSi n'est généralement pas complète. Une couche résiduelle superficielle 22c non cristallisée demeure, il est alors nécessaire de prévoir une gravure pour l'éliminer.

Le document US 2004/0132258 A1 divulgue une solution visant à diminuer la résistance d'accès du transistor, dans le cas d'un substrat présentant un « recess », ou retrait en français. Cette solution n'est pas adaptée aux procédés d'intégration 3D.

Un objet de la présente invention est de pallier au moins en partie certains des inconvénients mentionnés ci-dessus.

En particulier, un objet de la présente invention est de proposer un procédé de formation d'une zone dopée améliorant la résistance d'accès d'un dispositif microélectronique.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, un premier aspect de l'invention concerne un procédé de formation d'au moins une zone dopée destinée à former une source ou un drain d'un transistor, comprenant les étapes suivantes :
- Fournir un empilement comprenant selon une direction z au moins une couche isolante, une couche active en un matériau semi-conducteur surmontant la couche isolante, et un motif de grille de transistor surmontant la couche active et présentant au moins un flanc latéral s'étendant dans un plan sensiblement perpendiculaire à une face supérieure de la couche active,
- Retirer une première portion de la couche active non surmontée par le motif de grille, ladite première portion s'étendant jusqu'à l'aplomb du motif de grille directement en bordure d'une deuxième portion de la couche active, ladite deuxième portion étant située sous le motif de grille, de sorte à exposer un bord de ladite deuxième portion, ledit bord s'étendant sensiblement dans un prolongement du flanc latéral du motif de grille,
- Former un premier espaceur en un premier matériau sur le flanc latéral et sur ledit bord, ledit premier espaceur présentant une forme de L et comprenant une portion basale au contact de la couche isolante et une portion latérale au contact du flanc latéral, ladite portion basale présentant une épaisseur selon la direction z sensiblement égale à l'épaisseur de la couche active,
- Former un deuxième espaceur en un deuxième matériau sur le premier espaceur, ledit deuxième espaceur présentant une forme complémentaire à celle du premier espaceur,
- Retirer la portion basale du premier espaceur par gravure sélective du premier matériau vis-à-vis du deuxième matériau du deuxième espaceur et du matériau semi-conducteur, de sorte à exposer le bord de la deuxième portion en conservant au moins en partie la portion latérale du premier espaceur sur le flanc latéral du motif de grille,
- Former par épitaxie à partir dudit bord exposé la zone dopée.

Avantageusement, le retrait de la première portion de la couche active est effectué avant la formation du premier espaceur. Cela permet de retirer la première portion au plus près du motif de grille. Après retrait de la première portion, le bord de la deuxième portion s'étend sensiblement en prolongement du flanc latéral. La formation de la zone dopée se fait à partir de ce bord. Ce bord devient ainsi une jonction entre la deuxième portion, typiquement le canal du transistor, et la zone dopée, typiquement la source ou le drain du transistor. Cette jonction est de préférence abrupte.

Un tel procédé supprime avantageusement la zone non dopée résiduelle qui se trouve à l'aplomb du ou des espaceurs, entre le canal et la zone dopée, lors de la mise en oeuvre des procédés connus. La jonction ainsi obtenue permet de diminuer la résistance d'accès du transistor. Comme indiqué précédemment en référence à la figure 1B illustrant l'art antérieur, un bombardement effectué dans le cadre des solutions connues ne permet pas de faire disparaître la zone non dopée, même si ce bombardement était modifié de sorte à incliner la direction de bombardement.

La formation de la zone dopée par épitaxie latérale, c'est-à-dire à partir du bord de la deuxième portion, permet en outre de s'affranchir de la nécessité de conserver un germe d'épitaxie sous-jacent à une portion modifiée, tel que mis en oeuvre par les procédés connus. Ainsi, le retrait de la première portion peut être effectué sur toute l'épaisseur de la couche active, jusqu'à la couche isolante, de sorte que la zone dopée présente une épaisseur au moins égale à celle de la couche active, sous les premier et deuxième espaceurs. Il n'est dès lors pas nécessaire de contrôler précisément une profondeur d'implantation, contrairement aux procédés connus. Cela permet de simplifier le procédé. Une zone dopée s'étendant selon toute la hauteur de la couche active permet en outre de diminuer la résistance d'accès du transistor.

Un tel procédé peut avantageusement être mis en oeuvre à basse température, typiquement pour des températures T < 600°C. Ce procédé est ainsi compatible avec une technologie d'intégration 3D.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1A à 1C illustrent en coupe des étapes de formation d'une zone dopée selon un procédé de l'art antérieur.
Les figures 2A à 2H illustrent en coupe des étapes de formation d'une zone dopée selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les dimensions relatives des différentes couches, portions et éléments du dispositif (par exemple espaceurs, couche active) ne sont pas représentatives de la réalité. Sur les dessins, un seul côté de la grille et un seul espaceur sont représentés. Il est entendu que le procédé s'applique de façon symétrique au deuxième côté de la grille et au deuxième espaceur. Ainsi, les figures peuvent être étendues par symétrie de part et d'autre de l'axe z.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la portion basale du premier espaceur présente une épaisseur selon la direction z sensiblement égale à l'épaisseur de la couche active. Une portion basale de premier espaceur présentant une épaisseur inférieure à l'épaisseur de la couche active ne permet pas de diminuer de façon optimale la résistance d'accès du transistor. Une portion basale de premier espaceur présentant une épaisseur supérieure à l'épaisseur de la couche active ne permet pas d'isoler correctement la grille du transistor. Une portion basale de premier espaceur présentant une épaisseur sensiblement égale à l'épaisseur de la couche active permet de diminuer la résistance d'accès du transistor de façon optimisée. Une épaisseur de portion basale « sensiblement égale » à l'épaisseur de la couche active signifie que l'épaisseur de portion basale est égale à l'épaisseur de la couche active à ±10%, de préférence à ±5%.

Selon un exemple, la sélectivité de la gravure sélective du premier matériau vis-à-vis du matériau semi-conducteur est supérieure ou égale à 10:1, et de préférence supérieure ou égale à 20:1.

Selon un exemple, la sélectivité de la gravure sélective du premier matériau vis-à-vis du deuxième matériau est supérieure ou égale à 5:1, et de préférence supérieure ou égale à 10:1.

Selon un exemple, la formation du premier espaceur comprend un dépôt d'une première couche non conforme, de sorte que la première couche présente une épaisseur e_{y} sur le flanc latéral et une épaisseur e_{z} sur la couche isolante, telles que l'épaisseur e_{y} soit inférieure à l'épaisseur e_{z}. Un premier espaceur formé à partir d'une première couche non conforme permet d'obtenir une portion basale d'espaceur plus épaisse que la portion latérale d'espaceur, de préférence tel que la portion basale d'espaceur présente une épaisseur sensiblement égale à l'épaisseur de la couche active. En outre, une portion latérale d'espaceur moins épaisse permet de contrôler plus finement et plus facilement la « dimension critique » connue par l'acronyme CD (« critical dimension » : c'est sur cette dimension que se base le contrôle dimensionnel des transistors).

Selon un exemple, le premier matériau et le deuxième matériau sont des matériaux diélectriques.

Selon un exemple, le premier matériau est à base d'oxyde de silicium ou à base de SiBCN.

Selon un exemple, le deuxième matériau est différent du premier matériau et est à base de nitrure de silicium SiN ou de SiCO ou d'un autre matériau comprenant au moins deux espèces parmi Si, C, O, B, N.

Selon un exemple, le matériau semiconducteur de la couche active est pris parmi le silicium et le silicium-germanium.

Selon un exemple, la zone dopée est à base de silicium ou de silicium-germanium.

Selon un exemple, l'épitaxie de la zone dopée est configurée pour que ladite zone dopée s'étende au-delà d'une face supérieure de la couche active selon une direction sensiblement perpendiculaire à la couche active.

Selon un exemple, le retrait de la première portion est effectué par gravure sèche anisotrope selon la direction z.

Selon un exemple, l'épitaxie de la zone dopée est une épitaxie latérale principalement dirigée selon une direction normale au bord de la deuxième portion.

Selon un exemple, le motif de grille de transistor sert de masque de gravure lors du retrait de la première portion.

Selon un exemple, l'épitaxie de la zone dopée est mise en œuvre avec un dopage *in situ* de façon à ce que la zone dopée présente directement un dopage à l'issue de ladite épitaxie.

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche en étant soit directement à son contact soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON).

En général, mais non limitativement, un espaceur forme une bague autour de la grille, avec un contour fermé ; la description d'un espaceur s'entend de préférence de cet espaceur unique autour de la grille ; cependant, les dessins d'illustration en coupe, généralement selon un plan transverse à la direction longitudinale des grilles, montrent deux parties d'espaceur de part et d'autre des flancs de la grille. Par extension, ces deux parties d'espaceur sont souvent désignées « les espaceurs ». Cette dernière terminologie peut éventuellement être adoptée dans cette demande, en l'occurrence « les premiers espaceurs » et/ou « les deuxièmes espaceurs ». Par ailleurs, l'invention s'étend aux modes de réalisation dans lesquels « les premiers espaceurs » et/ou « les deuxièmes espaceurs » sont discontinus.

La présente invention permet notamment la fabrication d'au moins un transistor ou d'une pluralité de transistors sur un substrat. Ce substrat peut être de type semi-conducteur sur isolant, par exemple un substrat silicium sur isolant SOI (acronyme de l'anglais « silicon on insulator ») ou un substrat germanium sur isolant GeOl (acronyme de l'anglais « germanium on insulator »).

L'invention peut également être mise en œuvre plus largement pour différents dispositifs ou composants micro-électroniques.

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, et peut désigner un ensemble de sous-étapes.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Les espaceurs sont typiquement formés en un matériau diélectrique.

Les termes « motif de grille », «empilement de grille », « grille » sont employés en synonymes.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B.

Dans la présente demande de brevet, on parlera préférentiellement d'épaisseur pour une couche, de hauteur pour un dispositif (transistor ou grille par exemple) et de profondeur pour une cavité ou une gravure. L'épaisseur est prise selon une direction normale au plan d'extension principal de la couche, la hauteur et la profondeur sont prises selon une direction normale au plan de base du substrat. Le plan d'extension principale de la couche, respectivement le plan de base du substrat est généralement parallèle à une face inférieure ou une face supérieure de cette couche, respectivement de ce substrat.

Dans la présente demande de brevet, un repère de préférence orthonormé formé par les axes x, y, z est représenté sur les dessins d'accompagnement. Le substrat, plus précisément sa face inférieure et/ou sa face supérieure, s'étendent dans le plan basal xy.

Dans la suite, la longueur est prise selon la direction portée par l'axe x, la largeur est prise selon la direction portée par l'axe y.

Un élément situé « à l'aplomb » ou « au droit d'» un autre élément signifie que ces deux éléments sont situés tous deux sur une même ligne perpendiculaire au plan basal, soit sur une même ligne orientée selon l'axe z sur les figures. Un élément situé « en prolongement » d'un autre élément signifie que ces deux éléments sont orientés tous deux selon une même direction ou un même plan, et de préférence en continuité l'un de l'autre.

On entend par « horizontale » ou « basale » une orientation parallèle à un plan xy. On entend par « verticale » une orientation parallèle à l'axe z.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

L'invention va maintenant être décrite en détail au travers de quelques modes de réalisation non limitatifs.

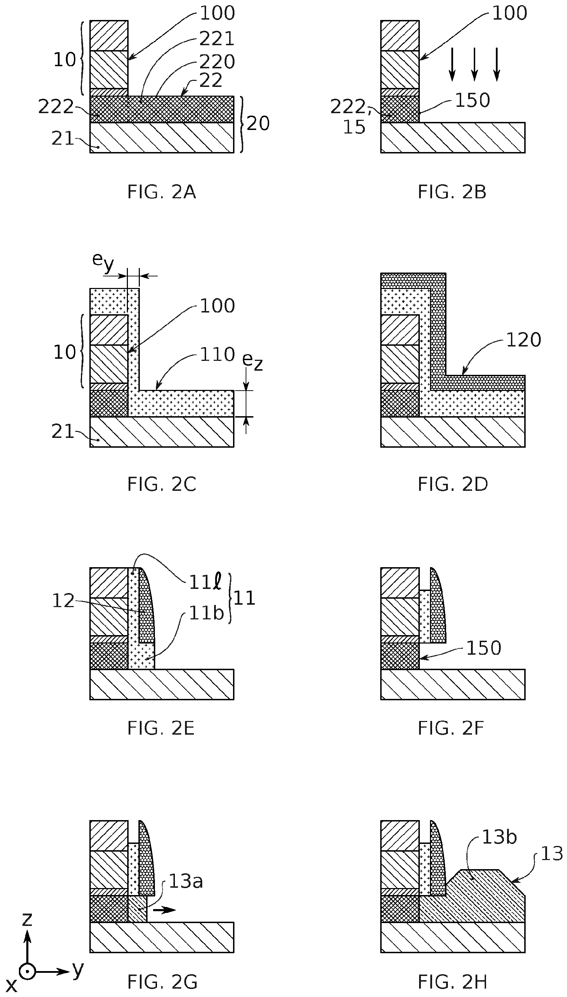

Un premier mode de réalisation du procédé est illustré aux figures 2A-2H.

Ce procédé est de préférence mis en œuvre sur une structure initiale comprenant un motif de grille 10 et un substrat 20, telle qu'illustrée à la figure 2A par exemple.

Le substrat 20 peut typiquement être un substrat de type semi-conducteur sur isolant, par exemple un substrat silicium sur isolant SOI (acronyme de l'anglais « silicon on insulator) ou un substrat germanium sur isolant GeOl (acronyme de l'anglais « germanium on insulator).

Un tel substrat 20 de type SOI comprend typiquement :
- un support en silicium massif présentant typiquement une épaisseur de plusieurs centaines de µm (non illustré) dénommé Si bulk (signifiant silicium massif),
- une couche 21 enterrée en dioxyde de silicium, dénommée BOX (acronyme de « Burried Oxide » signifiant oxyde enterré). Cette couche 21 présente typiquement une épaisseur comprise entre 30 nm et 200 nm, par exemple de l'ordre de 40 nm.
- une couche active 22 en silicium, dénommée top Si (signifiant silicium supérieur). Cette couche active 22 présente de préférence une épaisseur comprise entre 5 nm et 50 nm, par exemple de l'ordre de 10 nm.

La couche active 22 est surmontée d'un empilement de grille ou motif de grille 10. De manière classique, le motif de grille 10 peut présenter successivement les couches suivantes disposées à partir de la couche active 22 : une couche d'oxyde d'interface (souvent désignée oxyde de grille), une grille en silicium polycristallin dit polySi et un masque dur. Alternativement, ce motif de grille peut comprendre une couche à haute constante diélectrique, dite couche « high k » surmontée par une grille métallique.

Le motif de grille 10 présente typiquement une hauteur selon l'axe z de plusieurs dizaines de nanomètres à plusieurs centaines de nanomètres. L'invention couvre également un mode de réalisation alternatif pour lequel le motif de grille 10 est un motif sacrificiel destiné à être retiré après réalisation des espaceurs, puis à être remplacé par un autre empilement de grille formant une grille 10. Un tel procédé est couramment qualifié de « gate last » selon la terminologie anglo-saxonne. La grille 10 dans la suite désigne donc indifféremment un empilement de grille de type « gate first » (la grille est conservée à l'issue de la réalisation des espaceurs) ou de type « gate last » (la grille est remplacée à l'issue de la réalisation des espaceurs).

Dans la suite de la description, et par souci de concision, le motif de grille sera simplement désigné grille 10. La couche active est désignée topSi 22. La zone dopée destinée à former la source ou le drain du transistor est désignée zone S/D 13.

Après structuration ou fourniture de la grille 10 et avant formation du premier espaceur 11 sur les flancs 100 de la grille 10, une première portion 221 du topSi 22, qui n'est ni masquée, ni couverte par la grille 10 ou par des espaceurs, est retirée (figure 2B). La grille 10 forme ainsi un masque de gravure pour le retrait de la portion 221. Le retrait de cette première portion 221 expose un bord 150 d'une deuxième portion 222 de topSi couverte par la grille 10, formant le canal 15 du transistor. Ce bord 150 entre les première et deuxième portions 221, 222 est sensiblement parallèle à l'axe z et se situe dans un prolongement du flanc 100 de la grille 10. Cela permet d'aligner ultérieurement la jonction entre le canal et la zone S/D du transistor directement en bordure de la grille 10. Cela évite qu'une portion non dopée subsiste entre le canal 15 et la zone S/D ultérieurement formée. La résistance d'accès au transistor est alors diminuée.

La première portion 221 présente, de préférence, une épaisseur e_{z} égale à l'épaisseur de la couche active 22. Cela évite qu'une portion non dopée subsiste en dehors du canal 15, sous la zone S/D ultérieurement formée. La résistance d'accès au transistor est alors encore diminuée. Comme la portion 221 à retirer s'étend selon z jusqu'au BOX 21, il n'est pas nécessaire de contrôler précisément la profondeur du retrait. Le BOX 21 peut ainsi servir de couche d'arrêt pour le retrait du topSi.

Le retrait de la première portion 221 est de préférence effectué par gravure sèche anisotrope et principalement dirigée selon z. Ce retrait n'affecte donc pas la deuxième portion 222 masquée par la grille 10, selon cette direction z. De façon connue de l'homme du métier, une telle gravure sèche anisotrope peut se faire par plasma, par exemple en utilisant une chimie de gravure HBr/O2 ou CH2F2 / SF6 / N2 / He, au sein d'un réacteur plasma à couplage capacitif (CCP) ou d'un réacteur plasma à couplage inductif (ICP). Selon une possibilité, la portion 221 est amorphisée avant retrait par gravure.

Les premier et deuxième espaceurs 11, 12 sont formés après retrait de la première portion 221 du topSi 22.

Un premier dépôt d'une première couche 110 en un premier matériau diélectrique sur la grille 10 et sur la couche active 22 est typiquement effectué (figure 2C). Ce premier dépôt est de préférence non conforme, de façon à obtenir une couche 110 présentant une épaisseur e_{z} sensiblement égale à l'épaisseur de la deuxième portion 222 de la couche active 22, au niveau d'une partie basale de la couche 110 au contact du BOX 21, et une épaisseur e_{y} < e_{z} au niveau d'une partie latérale de la couche 110 au contact du flanc latéral 100 du motif de grille 10. L'épaisseur e_{y} peut être comprise entre 2 nm et 10 nm. Le premier matériau diélectrique peut être un oxyde de silicium ou à base de SiBCN, ou encore à base de SiCO (silicium carbone oxygène).

Un deuxième dépôt d'une deuxième couche 120 en un deuxième matériau diélectrique est ensuite effectué sur la première couche 110 (figure 2D). Ce deuxième dépôt peut être conforme. L'épaisseur de la deuxième couche 120 peut être comprise entre 5 nm et 30 nm. Le deuxième matériau diélectrique peut être à base de nitrure de silicium SiN. Les premier et deuxième matériaux diélectriques sont différents l'un de l'autre.

Une ou plusieurs étapes de gravure anisotrope selon l'axe z permettent ensuite de retirer des portions horizontales des deux couches diélectriques 110, 120 au sommet de la grille 10 et sur le BOX 21, tout en conservant des portions 11l, 11b, 12 de couches diélectriques sur le flanc 100 de la grille 10 et sur le bord 150 de la deuxième portion 222 destinée à former le canal 15. Ces portions 11l, 11b, 12 forment les premier et deuxième espaceurs 11, 12, également dénommés double espaceur. Le premier espaceur 11 présente ainsi typiquement une forme de L et comprend la portion basale 11b et la portion latérale 11l. Le deuxième espaceur 12 couvre en partie le premier espaceur 11 (figure 2E).

Une gravure sélective configurée pour retirer la portion basale 11b du premier espaceur 11 est ensuite effectuée, de façon à exposer le bord 150 de la deuxième portion 222 destinée à former le canal 15. Cette gravure sélective présente de préférence une sélectivité supérieure à 5:1 entre le premier matériau diélectrique et le deuxième matériau diélectrique. Cela permet de retirer la portion basale 11b en conservant le deuxième espaceur 12 (figure 2F). Cette gravure sélective présente, de préférence, une sélectivité supérieure à 10:1 entre le premier matériau diélectrique et le matériau semi-conducteur. Cela permet de retirer la portion basale 11b en préservant le canal 15.

Une telle gravure sélective peut être effectuée par voie humide, à partir d'une solution d'acide fluorhydrique dilué (dHF) par exemple. Une telle gravure sélective peut être effectuée par voie sèche, notamment par plasma à base d'au moins une espèce comprenant un atome de fluor ou de carbone. La gravure plasma de SiO2 peut se faire sélectivement par rapport au Si, et de façon anisotrope, à partir des espèces ou des mélanges d'espèces suivants: CHF3/O2, C2F6, C3F8, C5F8/CO/O2/Ar. Typiquement, des rapports élevés entre les atomes de fluor et les atomes de carbone permettent d'obtenir une sélectivité de gravure élevée.

Cette gravure sélective permet d'exposer le bord 150 du canal 15. Ce bord 150 est sensiblement parallèle à z, dans un prolongement du flanc 100 de la grille 10. Ce bord 150 est avantageusement utilisé pour former par épitaxie latérale, selon une direction sensiblement perpendiculaire au bord 150, la zone dopée 13. Le bord 150 devient dès lors une interface formant une jonction entre le canal 15 et la zone dopée 13. Cette jonction est avantageusement située directement en bordure de la grille 10, à l'aplomb du flanc 100. La résistance d'accès au transistor peut ainsi être diminuée.

Comme illustré aux figures 2G, 2H, l'épitaxie latérale se fait à partir du bord 150, de préférence uniquement à partir du bord 150, d'abord et principalement selon l'axe y (portion 13a de la zone dopée 13 sur la figure 2G). Cette épitaxie de la zone dopée 13 peut se poursuivre en partie selon z (portion 13b de la zone dopée 13 sur la figure 2H). Une telle configuration de transistor 1 comprenant des zones S/D surélevées est appelée RSD, acronyme anglais de « Raised Source/Drain ».

Un procédé d'épitaxie dopée *in situ* est de préférence mis en œuvre pour former la zone dopée 13. Un dopage bore ( :B) ou phosphore ( :P) peut ainsi être obtenu. La zone dopée 13 peut être par exemple à base de SiGe:B, Si:B ou Si:P.

Selon une possibilité, une cavité se forme entre le BOX 21 et la zone dopée 13, 13b, lors de l'épitaxie latérale. Une telle cavité améliore l'isolation électrique entre la zone dopée 13 et le substrat sous-jacent au BOX 21.

## Revendications

1. Procédé de formation d'au moins une zone dopée (13) destinée à former une source ou un drain d'un transistor (1), comprenant les étapes suivantes :
• Fournir un empilement comprenant selon une direction z au moins une couche isolante (21), une couche active (22) en un matériau semi-conducteur surmontant la couche isolante (21), et un motif de grille (10) de transistor surmontant la couche active (22) et présentant au moins un flanc latéral (100) s'étendant dans un plan sensiblement perpendiculaire à une face supérieure (220) la couche active (22),
• Retirer une première portion (221) de la couche active (22) non surmontée par le motif de grille (10), ladite première portion (221) s'étendant jusqu'à l'aplomb du motif de grille (10) directement en bordure d'une deuxième portion (222, 15) de la couche active (22), ladite deuxième portion (222, 15) étant située sous le motif de grille (10), de sorte à exposer un bord (150) de ladite deuxième portion (222, 15), ledit bord (150) s'étendant dans un prolongement du flanc latéral (100) du motif de grille (10),
• Former un premier espaceur (11) en un premier matériau sur le flanc latéral (100) et sur ledit bord (150), ledit premier espaceur (11) présentant une forme de L et comprenant une portion basale (11b) au contact de la couche isolante (21) et une portion latérale (11l) au contact du flanc latéral (100), ladite portion basale (11b) présentant une épaisseur selon la direction z sensiblement égale à l'épaisseur de la couche active (22),
• Former un deuxième espaceur (12) en un deuxième matériau sur le premier espaceur (11), ledit deuxième espaceur (12) présentant une forme complémentaire à celle du premier espaceur (11),
• Retirer la portion basale (11b) du premier espaceur (11) par gravure sélective du premier matériau vis-à-vis du deuxième matériau du deuxième espaceur (12) et du matériau semi-conducteur, de sorte à exposer le bord (150) de la deuxième portion (222, 15) en conservant au moins en partie la portion latérale (11l) du premier espaceur (11) sur le flanc latéral (100) du motif de grille (10),
• Former par épitaxie à partir dudit bord (150) exposé la zone dopée (13).

2. Procédé selon la revendication précédente dans lequel la sélectivité de la gravure sélective du premier matériau vis-à-vis du matériau semi-conducteur est supérieure ou égale à 10 :1, et de préférence supérieure ou égale à 20 :1.

3. Procédé selon l'une quelconque des revendications précédentes dans lequel la sélectivité de la gravure sélective du premier matériau vis-à-vis du deuxième matériau est supérieure ou égale à 5:1, et de préférence supérieure ou égale à 10:1.

4. Procédé selon l'une quelconque des revendications précédentes dans lequel la formation du premier espaceur (11) comprend un dépôt d'une première couche (110) non conforme, de sorte que la première couche (110) présente une épaisseur e_{y} sur le flanc latéral (100) et une épaisseur e_{z} sur la couche isolante (21), telles que l'épaisseur e_{y} soit inférieure à l'épaisseur e_{z}.

5. Procédé selon l'une quelconque des revendications précédentes dans lequel le matériau semiconducteur de la couche active (22) est pris parmi le silicium et le silicium-germanium, et dans lequel la zone dopée (13) est à base de silicium ou de silicium-germanium.

6. Procédé selon l'une quelconque des revendications précédentes dans lequel le premier matériau et le deuxième matériau sont des matériaux diélectriques.

7. Procédé selon l'une quelconque des revendications précédentes dans lequel le premier matériau est à base d'oxyde de silicium ou à base de SiBCN, et dans lequel le deuxième matériau est différent du premier matériau et est à base de nitrure de silicium SiN ou de SiCO ou d'un autre matériau comprenant au moins deux espèces parmi Si, C, O, B, N.

8. Procédé selon l'une quelconque des revendications précédentes dans lequel l'épitaxie de la zone dopée est configurée pour que ladite zone dopée (13) s'étende au-delà de la face supérieure (220) de la couche active (22) selon une direction sensiblement perpendiculaire à la couche active (22).

9. Procédé selon l'une quelconque des revendications précédentes dans lequel le retrait de la première portion (221) est effectué par gravure sèche anisotrope selon la direction z.

10. Procédé selon l'une quelconque des revendications précédentes dans lequel l'épitaxie de la zone dopée (13) est une épitaxie latérale issue uniquement à partir du bord (150) de la deuxième portion (222, 15).

11. Procédé selon l'une quelconque des revendications précédentes dans lequel le motif de grille (10) de transistor sert de masque de gravure lors du retrait de la première portion (221).

12. Procédé selon l'une quelconque des revendications précédentes dans lequel l'épitaxie de la zone dopée (13) est mise en œuvre avec un dopage *in situ* de façon à ce que la zone dopée (13) présente directement un dopage à l'issue de ladite épitaxie.

## Patentansprüche

1. Verfahren zur Bildung mindestens eines dotierten Bereichs (13) zur Bildung einer Quelle oder eines Drains eines Transistors (1), umfassend die folgenden Schritte:
• Bereitstellen eines Stapels, der in einer z-Richtung mindestens eine Isolierschicht (21), eine aktive Schicht (22) aus einem Halbleitermaterial umfasst, die die Isolierschicht (21) überlagert, und ein Transistor-Gittermuster (10), das die aktive Schicht (22) überlagert und mindestens eine Seitenflanke (100) aufweist, die sich in einer Ebene im Wesentlichen senkrecht zu einer Oberseite (220) der aktiven Schicht (22) erstreckt,
• Entfernen eines ersten Abschnitts (221) der aktiven Schicht (22), der nicht vom Gittermuster (10) überlagert wird, wobei sich der erste Abschnitt (221) bis zur Senkrechten des Gittermusters (10) erstreckt, direkt am Rand eines zweiten Abschnitts (222, 15) der aktiven Schicht (22), wobei der zweite Abschnitt (222, 15) sich unter dem Gittermuster (10) befindet, so dass eine Kante (150) des zweiten Abschnitts (222, 15) freigelegt wird, wobei sich die Kante (150) in einer Verlängerung der Seitenflanke (100) des Gittermusters (10) erstreckt,
• Bilden eines ersten Abstandshalters (11) aus einem ersten Material an der Seitenflanke (100) und an der Kante (150), wobei der erste Abstandshalter (11) eine L-Form aufweist und einen Basalabschnitt (11b) in Kontakt mit der Isolierschicht (21) und einen Seitenabschnitt (111) in Kontakt mit der Seitenflanke (100) umfasst, wobei der Basalabschnitt (11b) eine Dicke in der z-Richtung aufweist, die im Wesentlichen gleich der Dicke der aktiven Schicht (22) ist,
• Bilden eines zweiten Abstandshalters (12) aus einem zweiten Material auf dem ersten Abstandshalter (11), wobei der zweite Abstandshalter (12) eine Form aufweist, die der des ersten Abstandshalters (11) entspricht,
• Entfernen des Basalabschnitts (11b) des ersten Abstandshalters (11) durch selektives Ätzen des ersten Materials gegenüber dem zweiten Material des zweiten Abstandshalters (12) und dem Halbleitermaterial, so dass die Kante (150) des zweiten Abschnitts (222, 15) freigelegt wird, wobei der Seitenabschnitt (111) des ersten Abstandshalters (11) mindestens teilweise an der Seitenflanke (100) des Gittermusters (10) erhalten bleibt,
• Bilden durch Epitaxie ausgehend von der freiliegenden Kante (150) des dotierten Bereichs (13).

2. Verfahren nach dem vorhergehenden Anspruch, wobei die Selektivität des selektiven Ätzens des ersten Materials gegenüber dem Halbleitermaterial größer oder gleich 10:1 und vorzugsweise größer oder gleich 20:1 ist.

3. Verfahren nach einem der vorhergehenden Ansprüche, wobei die Selektivität des selektiven Ätzens des ersten Materials gegenüber dem zweiten Material größer oder gleich 5:1 und vorzugsweise größer oder gleich 10:1 ist.

4. Verfahren nach einem der vorhergehenden Ansprüche, wobei die Bildung des ersten Abstandhalters (11) die Ablagerung einer nicht konformen ersten Schicht (110) umfasst, so dass die erste Schicht (110) eine Dicke e_{y} an der Seitenflanke (100) und eine Dicke e_{z} an der Isolierschicht (21) aufweist, so dass die Dicke e_{y} kleiner als die Dicke e_{z} ist.

5. Verfahren nach einem der vorhergehenden Ansprüche, wobei das Halbleitermaterial der aktiven Schicht (22) aus Silizium und Siliziumgermanium entnommen wird und wobei der dotierte Bereich (13) auf Silizium- oder Siliziumgermaniumbasis beruht.

6. Verfahren nach einem der vorhergehenden Ansprüche, wobei das erste Material und das zweite Material dielektrische Materialien sind.

7. Verfahren nach einem der vorhergehenden Ansprüche, wobei das erste Material auf Siliziumoxid- oder SiBCN-Basis beruht, und wobei das zweite Material sich vom ersten Material unterscheidet und auf Siliziumnitrid-SiN- oder SiCO-Basis oder einem anderen Material beruht, das mindestens zwei Arten von Si, C, O, B, N umfasst.

8. Verfahren nach einem der vorhergehenden Ansprüche, wobei die Epitaxie des dotierten Bereichs so eingerichtet ist, dass sich der dotierte Bereich (13) über die Oberseite (220) der aktiven Schicht (22) in einer Richtung im Wesentlichen senkrecht zur aktiven Schicht (22) erstreckt.

9. Verfahren nach einem der vorhergehenden Ansprüche, wobei das Entfernen des ersten Abschnitts (221) durch anisotropes Trockenätzen in z-Richtung erfolgt.

10. Verfahren nach einem der vorhergehenden Ansprüche, wobei die Epitaxie des dotierten Bereichs (13) eine laterale Epitaxie ist, die nur aus der Kante (150) des zweiten Abschnitts (222, 15) hervorgeht.

11. Verfahren nach einem der vorhergehenden Ansprüche, wobei das Transistor-Gittermuster (10) beim Entfernen des ersten Abschnitts (221) als Graviermaske dient.

12. Verfahren nach einem der vorhergehenden Ansprüche, wobei die Epitaxie des dotierten Bereichs (13) mit einer In-situ-Dotierung durchgeführt wird, so dass der dotierte Bereich (13) nach der Epitaxie direkt dotiert wird.

## Claims

1. Method for forming at least one doped area (13) intended to form a source or drain of a transistor (1), comprising the following steps:
• Providing a stack comprising in a direction z at least one insulating layer (21), an active layer (22) made of a semiconductor material overlying the insulating layer (21), and a transistor gate pattern (10) overlying the active layer (22) and having at least one lateral flank (100) extending in a plane substantially perpendicular to an upper face (220) of the active layer (22),
• Removing a first portion (221) of the active layer (22) not overlaid by the gate pattern (10), said first portion (221) extending up to vertically in line with the gate pattern (10) directly at the rim of a second portion (222, 15) of the active layer (22), said second portion (222, 15) being located under the gate pattern (10), so as to expose an edge (150) of said second portion (222, 15), said edge (150) extending in an extension of the lateral flank (100) of the gate pattern (10),
• Forming a first spacer (11) in a first material on the lateral flank (100) and on said edge (150), said first spacer (11) having an L-shape and comprising a base portion (11b) in contact with the insulating layer (21) and a lateral portion (111) in contact with the lateral flank (100), said base portion (11b) having a thickness along the direction z substantially equal to the thickness of the active layer (22),
• Forming a second spacer (12) from a second material on the first spacer (11), said second spacer (12) having a shape complementary to that of the first spacer (11),
• Remove the base portion (11b) of the first spacer (11) by selectively etching the first material with respect to the second material of the second spacer (12) and the semiconductor material, so as to expose the edge (150) of the second portion (222, 15) while at least partially retaining the side portion (111) of the first spacer (11) on the lateral flank (100) of the gate pattern (10),
• Forming the doped zone (13) by epitaxy from said exposed edge (150).

2. Method according to the preceding claim, wherein the selectivity of the selective etching of the first material with respect to the semiconductor material is greater than or equal to 10:1, and preferably greater than or equal to 20:1.

3. Method according to either one of the preceding claims, wherein the selectivity of the selective etching of the first material with respect to the second material is greater than or equal to 5:1, and preferably greater than or equal to 10:1.

4. Method according to any one of the preceding claims, wherein the formation of the first spacer (11) comprises a deposition of a non-compliant first layer (110), such that the first layer (110) has a thickness e_{y} on the lateral flank (100) and a thickness e_{z} on the insulating layer (21), so that the thickness e_{y} is less than the thickness e_{z}.

5. Method according to any one of the preceding claims, wherein the semiconductor material of the active layer (22) is taken from silicon and silicon-germanium, and wherein the doped zone (13) is based on silicon or silicon-germanium.

6. Method according to any one of the preceding claims, wherein the first material and the second material are dielectric materials.

7. Method according to any one of the preceding claims, wherein the first material is based on silicon oxide or SiBCN, and wherein the second material is different from the first material and is based on silicon nitride SiN or SiCO or another material comprising at least two species from Si, C, O, B, N.

8. Method according to any one of the preceding claims, wherein the epitaxy of the doped zone is configured for said doped zone (13) to extend beyond the upper face (220) of the active layer (22) in a direction substantially perpendicular to the active layer (22).

9. Method according to any one of the preceding claims, wherein the removal of the first portion (221) is performed by anisotropic dry etching along the direction z.

10. Method according to any one of the preceding claims, wherein the epitaxy of the doped area (13) is a lateral epitaxy originating only from the edge (150) of the second portion (222, 15).

11. Method according to any one of the preceding claims, wherein the transistor gate pattern (10) serves as an etch mask when removing the first portion (221).

12. Method according to any one of the preceding claims, wherein the epitaxy of the doped area (13) is implemented with *in situ* doping so that the doped area (13) shows directly doping at the end of said epitaxy.
